Europäisches Patentamt

European Patent Office

Office européen des brevets

(11) Publication number: **0 050 529**
**B1**

## (12) EUROPEAN PATENT SPECIFICATION

(45) Date of publication of patent specification: **07.01.88**

(51) Int. Cl.⁴: **G 11 C 11/24**

(21) Application number: **81304967.3**

(22) Date of filing: **22.10.81**

(54) Semiconductor memory circuit.

(30) Priority: **22.10.80 JP 147771/80**
**22.10.80 JP 147773/80**

(43) Date of publication of application:
**28.04.82 Bulletin 82/17**

(45) Publication of the grant of the patent:
**07.01.88 Bulletin 88/01**

(84) Designated Contracting States:
**DE FR GB NL**

(56) References cited:
**US-A-4 004 284**
**US-A-4 004 284**

**PATENTS ABSTRACTS OF JAPAN, vol. 3, no.
124 (E-144) 17th October 1979, page 113 E 144;
& JP - A - 54 101 230 (NIPPON DENKI K.K.)
09-08-1979**

**1979 IEEE INTERNATIONAL SOLID-STATE
CIRCUITS CONFERENCE, 15th February 1979,
pages 142-143, IEEE, New York, US; J.M. LEE
et al.: "Dynamic memories - A 80ns 5V-only
dynamic RAM"**

(73) Proprietor: **FUJITSU LIMITED**
**1015, Kamikodanaka Nakahara-ku
Kawasaki-shi Kanagawa 211 (JP)**

(72) Inventor: **Takemae, Yoshihiro
1-20-5-9-301, Utsukushigaoka
Midori-ku Yokohama-shi Kanagawa 227 (JP)**

(74) Representative: **Fane, Christopher Robin King
et al
HASELTINE LAKE & CO. Hazlitt House 28
Southampton Buildings Chancery Lane
London, WC2A 1AT (GB)**

## Description

The present invention relates to a semiconductor memory circuit and, more particularly, to a dynamic semiconductor memory circuit which employs rows and columns provided with so-called one transistor storage cells.

In recent years, the one-transistor storage cell type memory device has been widely utilized as a random access memory (RAM) device of the MIS integrated semiconductor memory circuit. Such a RAM device has already been disclosed in U.S. Patent No. 4,045,783 or U.S. Patent No. 4,195,357, and can have many advantages over a conventional RAM. However, at the same time, such a RAM also has some defects. The present invention is concerned particularly with two such defects. One defect resides in that read data from the RAM often contains errors due to a change in the level of the voltage of the power source. The other defect resides in that errors in the RAM system often occur due to a change in the level of the back gate voltage ($V_{BB}$) for biasing the substrate, in which the change of $V_{BB}$ is necessarily created in accordance with a voltage change developed in the bit (column) line.

Therefore, it is desirable to provide a semiconductor memory circuit which can overcome both the aforementioned defects simultaneously, although the two defects themselves have no similarity with each other.

According to the present invention as claimed, there is provided a semiconductor memory circuit comprising: a plurality of word lines; a plurality of bit lines; respective memory cells located at cross points of the word lines and the bit lines, each memory cell being comprised of a capacitor, having a first electrode and a second electrode, and a transfer-gate transistor connected in series with the capacitor at the first electrode thereof; a plurality of pre-charge circuits each arranged for charging one corresponding bit line to a pre-charge voltage derived from a memory power source; a plurality of sense amplifiers each arranged for amplifying the voltage level developed at one corresponding bit line so as to have a high voltage level or a low voltage level in accordance with the charge stored in one of the capacitors corresponding to that bit line; first circuitry employed for supplying to the pre-charge circuit the said pre-charge voltage the level of which is halfway between the said high voltage level and the said low voltage level; and second circuitry connected for applying a predetermined voltage to each said capacitor at the second electrode thereof; characterized in that the level of the said predetermined voltage applied by the said second circuitry is halfway between the said high voltage level and the said low voltage level developed at a bit line.

US—A—4,004,284 discloses a semiconductor memory circuit as in the precharacterizing part of claim 1 having first circuitry for supplying to a pre-charge circuit a pre-charge voltage the level of which is halfway between the high voltage level and the low voltage level developed at the bit line, and second circuitry for applying a predetermined voltage to each memory cell capacitor. However, this prior art document is not concerned with overcoming the two afore-mentioned defects, nor does it suggest that the predetermined voltage applied by the second circuitry may be halfway between the high voltage level and the low voltage level.

Reference will now be made, by way of example, to the accompanying drawings, wherein:

Fig. 1 illustrates a circuit diagram of a conventional one-transistor storage cell type RAM circuit;

Fig. 2 depicts a graph, used for explaining the operation of the circuit shown in Fig. 1;

Fig. 3 illustrates a circuit diagram of another conventional one-transistor storage cell type RAM circuit;

Fig. 4 depicts a graph, used for explaining the operation of the circuit shown in Fig. 3;

Fig. 5 illustrates a circuit diagram of a further conventional one-transistor storage cell type RAM circuit;

Fig. 6 depicts a graph, used for explaining a "0" read operation of the circuit shown in Fig. 5;

Fig. 7 depicts a graph, used for explaining a "1" read operation of the circuit shown in Fig. 5;

Fig. 8 illustrates a circuit diagram of a semiconductor memory circuit embodying the present invention;

Fig. 9 depicts a graph, used for explaining a "0" read operation of the circuit shown in Fig. 8;

Fig. 10 depicts a graph, used for explaining a "1" read operation of the circuit shown in Fig. 8;

Fig. 11 illustrates an example of the dynamic pull-up circuit shown in Fig. 8;

Fig. 12 depicts a first graph, used for explaining the change of the backgate voltage $V_{BB}$; and

Fig. 13 depicts a second graph, used for explaining the change of $V_{BB}$.

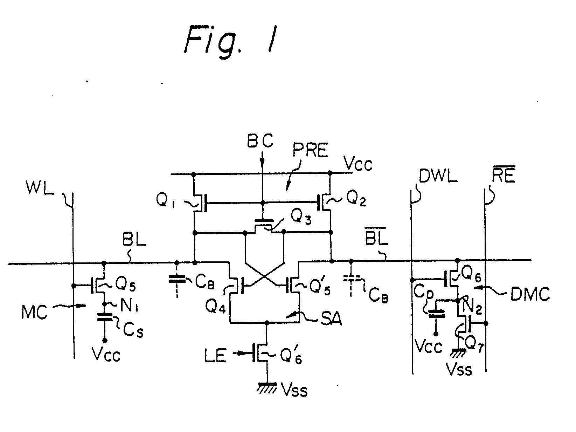

In Fig. 1 a sense amplifier SA comprises MIS transistors $Q_4$, $Q'_5$ and $Q'_6$, and is controlled by a signal LE. The reference symbols BL and $\overline{BL}$ represent a pair of bit lines which extend leftward and rightward respectively from the sense amplifier SA. The reference symbol PRE represents a pre-charge circuit comprising MIS transistors $Q_1$, $Q_2$ and $Q_3$. MC represents a memory cell comprising a MIS transistor $Q_5$, acting as a transfer-gate transistor, and a MIS capacitor $C_S$, acting as a storage capacitor. The capacitor $C_S$ has a pair of electrodes and the first electrode thereof is connected, via a node $N_1$, to the transistor $Q_5$. The reference symbol DMC represents a dummy cell comprising MIS transistors $Q_6$ and $Q_7$ and also a MIS capacitor $C_D$. The reference symbol WL represents a word line. A signal, appearing on the word line WL, makes the transfer-gate transistor $Q_5$ ON, then the stored information of the memory cell MC is transferred to the bit line BL. The reference symbol DWL represents a dummy word line. A signal, appearing on the dummy word line DWL, makes the MIS transistor $Q_6$ ON, then the dummy capacitor $C_D$ is connected with the bit line $\overline{BL}$. The reference symbol $\overline{RE}$ indicates a signal which makes the transistor $Q_7$ ON so as to discharge the capacitor $C_D$. That is, the voltage level at the node $N_2$ is changed to the low voltage level of a memory power source, specifically the voltage level $V_{SS}$ which is usually 0V. The reference symbol BC indicates a signal which makes MIS transistors $Q_1$, $Q_2$ and $Q_3$ ON simultaneously so that the level of both bit lines BL and $\overline{BL}$ is changed to the high level of the memory power source, specifically the voltage level $V_{CC}$ which is usually 5V. That is, the signal BC acts as a pre-charging signal. The bit lines BL and $\overline{BL}$ form the bit line parasitic capacitor $C_B$. The high voltage level $V_{CC}$ of the memory power source is also applied to one of the electrodes of each capacitor $C_S$ and $C_D$.

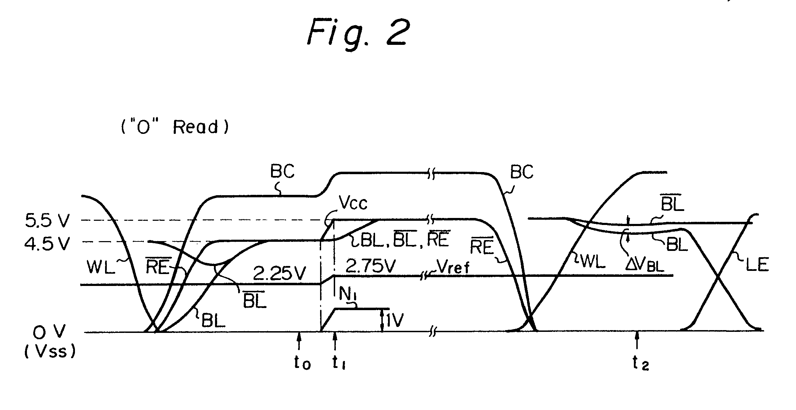

The graph of Fig. 2 indicates the operation of the circuit shown in Fig. 1 when information "0" is read from the memory cell MC. The level of the word line WL is changed to the low voltage level $V_{SS}$ after a write operation or a refresh operation has finished. Then the signals BC and $\overline{RE}$ are activated. Therefore, the bit lines BL and $\overline{BL}$ are pre-charged to the high voltage level $V_{CC}$, and the level at the node $N_2$, in the dummy cell DMC, is changed to the low voltage level $V_{SS}$, which is called stand-by status.

Generally, a semiconductor memory circuit must accept a power source voltage change of ±10%. Accordingly, when the high voltage level of the memory power source is designed to be 5V, the semiconductor memory circuit must be designed so as to operate without any error even though the power source voltage changes within the range between 4.5V and 5.5V. Returning to Fig. 2, the graph depicts, for example, a case where firstly information "0" has been written, during a condition of $V_{CC}=4.5V$, in the memory cell, i.e. the level at the node $N_1$ is changed to the level $V_{SS}$, and secondly the written inforamtion "0" has been read from the memory cell MC at a time $t_2$. However, a voltage change has occurred during the stand-by status, especially during the period from $t_0$ to $t_1$, from the level 4.5V to 5.5V. As is known, the capacity of the dummy capacitor $C_D$ and the capacity of the memory cell $C_S$ are determined so as to satisfy the following equation (1).

$$C_D = \frac{1}{2} C_S \qquad (1)$$

(Note the symbols $C_D$ and $C_S$ also denote the capacities of respective capacitors $C_D$ and $C_S$.)

If the power source voltage level is still maintained at 4.5V up to and after the time $t_2$, contrary to the graph of Fig. 2, each voltage drop produced in the bit lines $\overline{BL}$ and BL is respectively expressed by about

$$V_{CC}\frac{C_D}{C_B} \quad \text{and} \quad V_{CC}\frac{C_S}{C_B},$$

according to the above equation (1). That is, when the word line WL is activated (the dummy word line DWL is also activated), current flows from the bit lines BL and $\overline{BL}$ into the capacitors $C_S$ and $C_D$ respectively, via the nodes $N_1$ and $N_2$, and thus the voltage levels of the bit lines $\overline{BL}$ and BL are reduced by about the values of the aforesaid expressions

$$V_{CC}\frac{C_D}{C_B} \quad \text{and} \quad V_{CC}\frac{C_S}{C_B},$$

Accordingly, the voltage level $V_{\overline{BL}}$ of the bit line $\overline{BL}$ and the voltage level $V_{BL}$ of the bit line BL are respectively expressed by the following equations (2) and (3).

$$V_{\overline{BL}} = V_{CC} - V_{CC}\frac{C_D}{C_B} = 4.5 - 4.5\frac{C_D}{C_B}$$

$$= 4.5 - \frac{4.5}{2}\frac{C_S}{C_B} \qquad (2)$$

$$V_{BL} = V_{CC} - V_{CC}\frac{C_S}{C_B} = 4.5 - 4.5\frac{C_S}{C_B} \qquad (3)$$

From the above equations (2) and (3), the voltage difference $\Delta V_{BL}$, between the voltages of the bit lines BL and $\overline{BL}$, can be expressed by the following equation (4).

$$\Delta V_{BL} = |V_{BL} - V_{\overline{BL}}| = 2.25\frac{C_S}{C_B}(V) \qquad (4)$$

However, in Fig. 2, a voltage change of the power source occurs during the period $t_0$ through $t_1$ and the increased voltage 5.5 is maintained thereafter. In such a case, the voltage level ($V_{N1}$) at the node $N_1$ is pushed upward, via the capacitor $C_S$, by the aforesaid voltage increase of 1 (=5.5−4.5)V. Thus, the voltage levels $V_{\overline{BL}}$ and $V_{BL}$ of the bit lines $\overline{BL}$ and BL, respectively, are expressed by the following equations (5) and (6).

$$V_{\overline{BL}}=V_{CC}-V_{CC}\frac{C_D}{C_B} =5.5-5.5 \frac{C_D}{C_B}$$

$$=5.5-\frac{5.5}{2} \frac{C_S}{C_B} \tag{5}$$

$$V_{\overline{BL}}=V_{CC}-(V_{CC}-V_{N1})\frac{C_S}{C_B} =V_{CC}-(V_{CC}-1.0) \frac{C_S}{C_B}$$

$$=5.5-4.5\frac{C_S}{C_B} \tag{6}$$

As a result, the difference voltage $\Delta V_{BL}$, during the read operation after the time $t_2$, is reduced as defined by the following equation (7).

$$\Delta V_{BL}= | V_{BL}-V_{\overline{BL}} | =1.75\frac{C_S}{C_B} \tag{7}$$

It should be understood that, in the circuit of Fig. 1, the above mentioned reduction of voltage level (refer to the change in the above equations from (4) to (7)) cannot occur during the read operation of information "1". The reason is as follows. When information "1" is to be written in the memory cell MC, the voltage level at the node $N_1$ is changed to the level of $V_{CC}$. Therefore; when the above write operation finishes, the voltage level at the node $N_1$ is equal to 4.5V. If the voltage increase to 5.5V occurs thereafter, the voltage level at the node $N_1$ is pushed upward, via the capacitor $C_S$, to 5.5V. Under such circumstance, no charges are extracted from the bit line BL during the read operation of information "1", but charges, proportional to the value of

$$\frac{1}{2} C_S$$

are extracted from the bit line $\overline{BL}$, which operation is the same as the usual read operation when there is no change in the power source voltage. The reference symbol $V_{ref}$ indicates a threshold voltage level utilized for distinguishing between the "1" level and the "0" level.

As mentioned above, since the capacitors $C_S$ and $C_D$ are energized, at each one electrode thereof, by the voltage level $V_{CC}$, the above mentioned voltage reduction

$$(2.25\frac{C_S}{C_B} \rightarrow 1.75 \frac{C_S}{C_B})$$

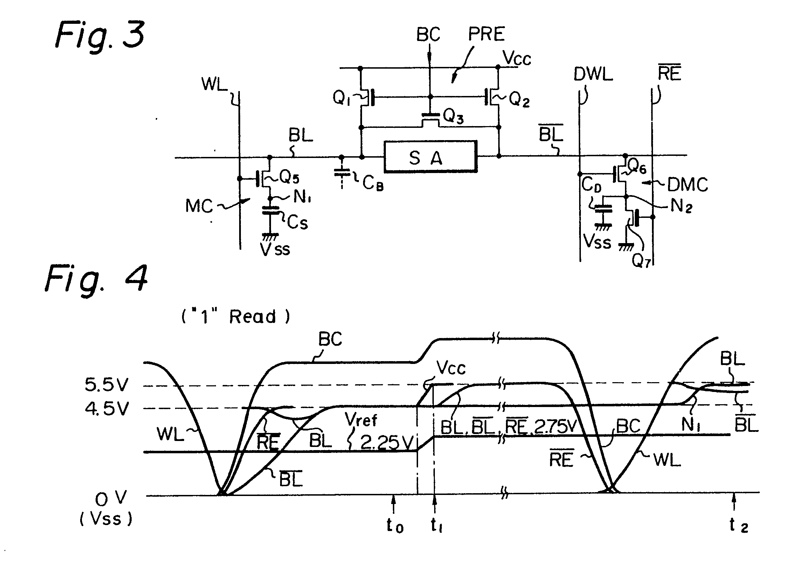

is induced during the "0" read operation. Contrary to the above, the voltage level $V_{CC}$ at the capacitors $C_S$ and $C_D$ of Fig. 1 can be substituted for the voltage level $V_{SS}$ through a manufacturing process in which, for example, impurities are injected, through an ion implantation process, into the areas located under the capacitors $C_S$ and $C_D$, where the impurities have a conductivity type opposite to that of the substrate. If the voltage level $V_{CC}$ at the capacitors $C_S$ and $C_D$ is replaced by the voltage level $V_{SS}$, there is a possibility that no voltage level change at the node $N_1$ will occur regardless of the power source voltage changes. Fig. 3 illustrates a circuit diagram of another conventional one-transistor storage cell type RAM circuit. In the circuit of Fig. 3, the above mentioned $V_{SS}$ is employed instead of $V_{CC}$ at the capacitors $C_S$ and $C_D$. The circuit of Fig. 3 can overcome the voltage reduction of $\Delta V_{BL}$ during the "0" read operation. However, contrary to this, identical voltage reduction of $\Delta V_{BL}$ is created during the "1" read operation. The graph of Fig. 4 depicts the "1" read operation of the circuit shown in Fig. 3. Firstly, information "1" has been written in the memory cell MC under the condition of $V_{CC}$=4.5V, and secondly the change of the power source voltage occurs during the period from the time $t_0$ to $t_1$, that is the voltage $V_{CC}$ is increased from 4.5V to 5.5V. If the

4

power source voltage level is still maintained at 4.5V up to and after the time $t_2$, contrary to the graph of Fig. 4, the voltage level $V_{\overline{BL}}$ is defined by the following equation (8).

$$V_{\overline{BL}}=V_{CC}-V_{CC}\frac{C_D}{C_B}=4.5-\frac{4.5}{2}\frac{C_S}{C_B} \qquad (8)$$

In such a circumstance, since the stored information of "1" at the node $N_1$ is represented by 4.5V, no charges are extracted from the bit line BL to the node $N_1$ when the word line WL is activated, and thus the following equation (9) is obtained.

$$V_{BL}=V_{CC}=4.5V \qquad (9)$$

From the above equations (8) and (9), the voltage difference $\Delta V_{BL}$ is expressed as follows.

$$\Delta V_{BL}= \mid V_{BL}-V_{\overline{BL}} \mid =2.25\frac{C_S}{C_B} \qquad (10)$$

The value $\Delta V_{BL}$ of the equation (10) is the same as that of the equation (4), and therefore, no voltage reduction is induced. However, if the power source voltage ($V_{CC}$) is increased, during the stand-by status as shown in Fig. 4, from 4.5V to 5.5V, the voltage level $V_{\overline{BL}}$ of the bit line $\overline{BL}$ is defined as follows.

$$V_{\overline{BL}}=V_{CC}-V_{CC}\frac{C_D}{C_B}=5.5-5.5\frac{C_D}{C_B}$$

$$=5.5-\frac{5.5}{2}\frac{C_S}{C_D} \qquad (11)$$

At this time, even though the voltage level $V_{CC}$ is increased to 5.5V, the voltage level $V_{N1}$ at the node $N_1$ is maintained as it is, that is 4.5V, because the transfer-gate transistor $Q_5$ is now OFF. Therefore, current flows from the bit line BL to the memory cell MC and the voltage level $V_{BL}$ can be defined as follows.

$$V_{BL}=V_{CC}-(V_{CC}-V_{N1})\frac{C_S}{C_B}=5.5-(5.5-4.5)\frac{C_S}{C_B}$$

$$=5.5-\frac{C_S}{C_B} \qquad (12)$$

Consequently, the voltage difference $\Delta V_{BL}$, at the time $t_2$ for achieving the read operation, is defined as follows,

$$\Delta V_{BL}= \mid V_{BL}-V_{\overline{BL}} \mid =1.75\frac{C_S}{C_B} \qquad (13)$$

As understood from the above recited equations (7) and (13), the undesired voltage reduction of $\Delta V_{BL}$ is inevitable in each of the circuits illustrated in Figs. 1 and 3.

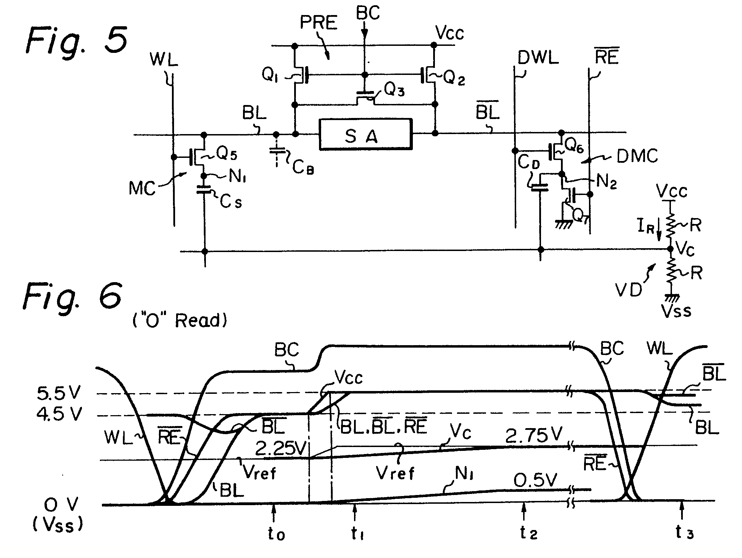

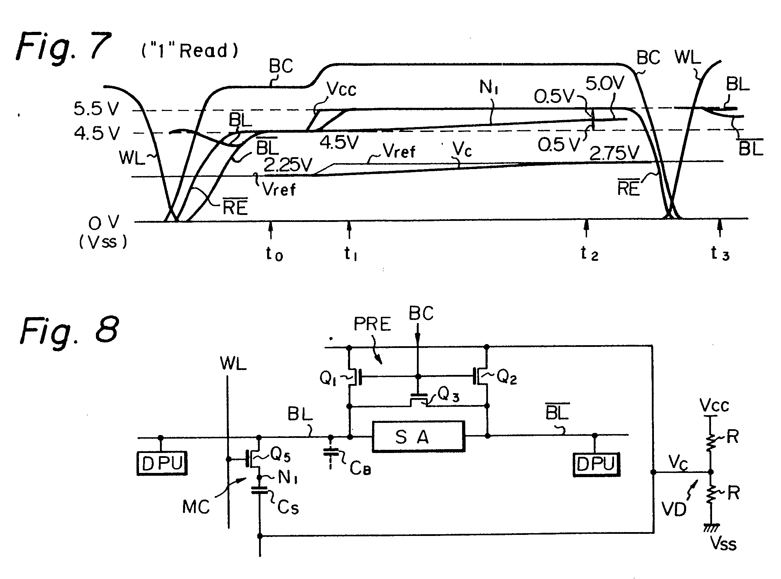

Fig. 5 illustrates a circuit diagram of a further conventional one-transistor storage cell type RAM circuit which contains an improvement regarding undesired voltage reduction of $\Delta V_{BL}$. Fig. 6 depicts a graph, used for explaining the "0" read operations of the circuit shown in Fig. 5. Also, Fig. 7 depicts a graph, used for explaining the "1" read operation of the circuit shown in Fig. 5. As seen from Fig. 5, the improvement is specifically represented by a voltage divider VD having two resistors R. The voltage divider VD produces an output voltage of $V_C$ which is equal to half of

$$V_{CC}(V_C=\frac{1}{2}V_{CC}).$$

The voltage $V_C$ is applied to both the capacitors $C_S$ and $C_D$, at each one electrode thereof. In the circuit of Fig. 5, when the write operation of information "0" is achieved at the condition of $V_{CC}=4.5V$ and the read operation thereof is also achieved at the condition of $V_{CC}=4.5V$, the voltage difference $\Delta V_{BL}$, during the read operation, is determined by the following equation (14).

$$\Delta V_{BL}=2.25\frac{C_S}{C_B} \tag{14}$$

If the power source voltage $V_{CC}$ changes from 4.5V to 5.5V during the period from the time $t_0$ to $t_1$, as illustrated in Fig. 6, and at the same time if the time $t_2$ is longer than the time $t_1$, the following equations (15) and (16) can be obtained, because the voltage level $V_C$ and the voltage level $(V_{N1})$ at the node $N_1$ change in such a manner as depicted in Fig. 6.

$$V_{\overline{BL}}=V_{CC}-V_{CC}\frac{C_D}{C_B}=5.5-5.5\frac{C_D}{C_B}=5.5-\frac{5.5}{2}\frac{C_S}{C_B}$$

$$=5.5-2.75\frac{C_S}{C_B} \tag{15}$$

$$V_{BL}=V_{CC}-(V_{CC}-V_{N1})\frac{C_S}{C_B}=5.5-(5.5-0.5)\frac{C_S}{C_B}$$

$$=5.5-5\frac{C_S}{C_B} \tag{16}$$

Consequently, the voltage difference $\Delta V_{BL}$, at the time $t_2$ for achieving the read operation, is expressed as follows.

$$\Delta V_{BL}=|V'_{BL}-V_{\overline{BL}}|=2.25\frac{C_S}{C_B} \tag{17}$$

It should be noted that the equation (17) is identical to the equation (14) and no voltage reduction of $\Delta V_{BL}$ is induced, which is also true in the case where the "1" read operation is conducted. That is, if the voltage level $V_{CC}$ is kept constant at 4.5V, the voltage difference $\Delta V_{BL}$ is expressed by the equation (18).

$$\Delta V_{BL}=2.25\frac{C_S}{C_B} \tag{18}$$

Similarly, even though the voltage level $V_{CC}$ changes during the period from time $t_0$ to $t_1$, if the read time $t_2$ is far longer than the time $t_1$, the following two equations stand.

$$V_{\overline{BL}}=V_{CC}-V_{CC}\frac{C_D}{C_B}=5.5-\frac{5.5}{2}\frac{C_S}{C_B} \tag{19}$$

$$V_{BL}=V_{CC}-(V_{CC}-V_{N1})\frac{C_S}{C_B}=5.5-(5.5-5)\frac{C_S}{C_B}$$

$$=5.5-0.5\frac{C_S}{C_B} \tag{20}$$

From the equations (19) and (20), the voltage difference $\Delta V_{BL}$ at the time $t_2$ includes no undesired voltage reduction, as represented by the following equation (21).

$$\Delta V_{BL}=|V_{BL}-V_{\overline{BL}}|=2.25\frac{C_S}{C_B} \tag{21}$$

This equation (21) is identical to the above recited equation (18).

The circuit of Fig. 5 is satisfactory from the view represented by the equations (17), (18) and (21). However, at the same time it has the following defects. The resistance value of each of the resistors R in Fig. 5 must be increased so as to reduce the power consumption produced from the resistors R. However, since the resistance value thereof is large, the voltage $V_C$ cannot quickly follow the change in $V_{CC}$. Accordingly, if the time $t_2$ is close to the time $t_1$, the value of $\Delta V_{BL}$ becomes small. For example, in a large capacity RAM which is of the order of 64 k bits, the capacity developed at the middle junction of resistors R in the voltage divider VD becomes about 1000 pF. If the resistance value of the resistor R is determined to be 2R=50 k$\Omega$, so as to suppress the amount of current $I_R$ below 0.1 mA, then the time constant $\tau$ in a change of $V_C$, when the voltage level $V_{CC}$ changes, is determined as follows. That is, $\tau$=2R $\cdot$ C=50 $\mu$S, which value of $\tau$ is extremely large. Due to the presence of such a large time constant $\tau$ in $V_C$, if the read operation is commenced immediately after the time $t_1$, the voltage difference $\Delta V_{BL}$ is reduced as defined by the following equation (22).

$$\Delta V_{BL}=1.75\frac{C_S}{C_B} \qquad (22)$$

This equation (22) is identical to the above recited equation (13).

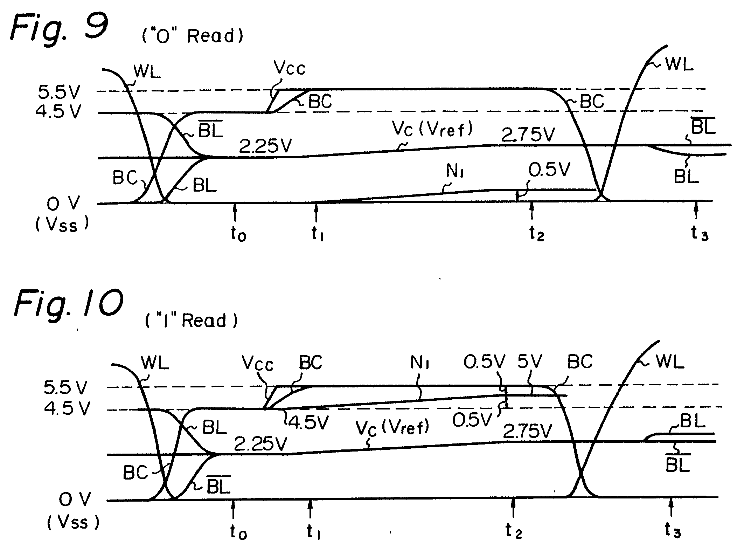

The present invention can improve the reduction of the voltage difference $\Delta V_{BL}$ represented by the equation (22), so that the voltage difference $\Delta V_{BL}$ is always kept at a constant large value even if a change of the power source voltage occurs at any time. The basic construction of the present invention is as follows. That is, first circuitry is employed for supplying the pre-charge voltage to the pre-charge circuit PRE, the level of that pre-charge voltage being defined as just the middle of the high voltage level and the low voltage level developed at the bit line. Also second circuitry is employed for supplying a predetermined voltage to the capacitor $C_S$ at the second electrode thereof. The said predetermined voltage to be supplied from said second circuitry is exactly the same as the voltage to be supplied from said first circuitry, the level of which voltage is defined as just the middle of said high voltage level and the low voltage level developed at the bit line. Fig. 8 illustrates a circuit diagram of a semiconductor memory circuit embodying the present invention. Fig. 9 depicts a graph, used for explaining the "0" read operation of the circuit shown in Fig. 8. And, Fig. 10 depicts a graph, used for explaining the "1" read operation of the circuit shown in Fig. 8. As mentioned above, a circuit embodying the present invention contains the aforesaid first circuitry and the second circuitry. The first circuitry supplies a pre-charge voltage to the pre-charge circuit PRE. The second circuitry supplies a predetermined voltage to the capacitor $C_S$, at the second electrode thereof. The term "second electrode" has already been explained with reference to Fig. 1. Preferably, the predetermined voltage from the second circuitry is exactly the same as the voltage from the first circuitry. Further, the output voltages from the said first and second circuitry are defined as just the middle of the high voltage level developed at the bit line and the low voltage level developed at the same bit line. Furthermore, said high voltage level and low voltage level may be selected to be $V_{CC}$ and $V_{SS}$ of the memory power source respectively. In this case, a dynamic pull-up circuit is necessary. Since the first and second circuitry produce the same output voltage, that is

$$\frac{1}{2}(V_{CC}+V_{SS}),$$

these circuits are fabricated as a single voltage divider. The circuit of Fig. 8 corresponds to a circuit which contains the above mentioned single voltage divider VD and the above mentioned dynamic pull-up circuits DPU. Referring to Fig. 8, this circuit is different from that of Fig. 5 from the following two view points. Firstly, the output voltage $V_C$ being equal to

$$\frac{1}{2}(V_{CC}+V_{SS})$$

from the voltage divider VD, is also applied to the pre-charge circuit PRE. Secondly, the voltage level of both the bit lines BL and $\overline{BL}$, appearing during the stand-by status, becomes

$$\frac{1}{2}V_{CC},$$

which level

$$\frac{1}{2}V_{CC}$$

has been pre-charged by the circuit PRE, and accordingly, the voltage itself of the bit line $\overline{BL}$ can be utilized as the aforesaid reference voltage $V_{ref}$. This means that the dummy cell DMC can be removed from the circuits illustrated in Figs. 1, 3 and 5, as shown in Fig. 8. In this case, the dynamic pull-up circuits DPU are connected to the bit lines BL and $\overline{BL}$. Although the dummy cell DMC is not illustrated in Fig. 8, this DMC can be left as it is, if necessary, because such cell is available for suppressing undesired noise.

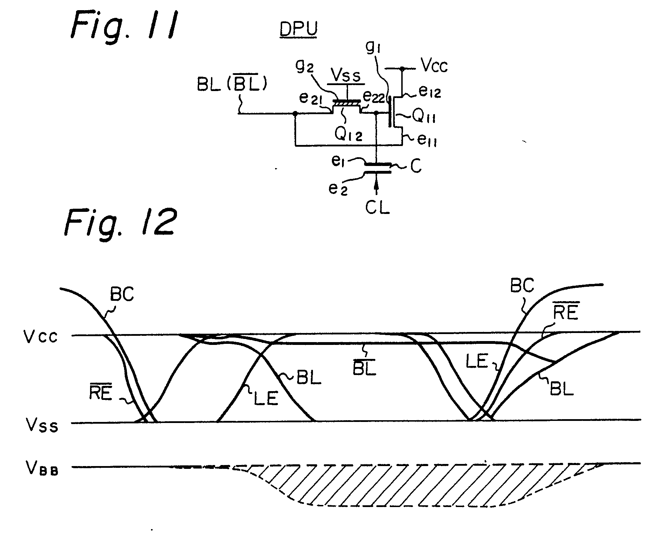

Fig. 11 illustrates one example of the dynamic pull-up circuit shown in Fig. 8. The dynamic pull-up circuit DPU is connected to each of the bit lines BL and $\overline{BL}$ so as to lead the aforesaid high voltage level of $V_{cc}$ thereto. The circuit DPU is comprised of an enhancement type MIS transistor $Q_{11}$, having a gate g1 and first and second electrodes e11 and e12, a depletion type MIS transistor $Q_{12}$, having a gate g2 and first and second electrodes e21 and e22, and a capacitor C, having a first electrode e1 and a second electrode e2 which receives a clock pulse CL. The first electrodes e11 and e21 of the said MIS transistors $Q_{11}$ and $Q_{12}$ respectively are connected with the bit line BL $(\overline{BL})$. The second electrode e22 of the depletion type MIS transistor, the gate g1 of the enhancement type MIS transistor and the first electrode e1 of the capacitor are commonly connected together. The gate g2 of the depletion type MIS transistor receives the voltage $V_{ss}$ and the second electrode e12 of the enhancement type MIS transistor receives the voltage $V_{cc}$. When the clock CL is supplied, the voltage level at the gate g1 is pushed upward over the voltage level of $V_{cc}$ under a bootstrap effect. However, this bootstrap effect becomes effective only when the voltage level of the bit line BL (or $\overline{BL}$) is high. If the voltage level is low, current flows through the transistor $Q_{12}$, and accordingly the voltage level at the gate g1 does not increase. As a result, if the voltage level of the bit line is high, the transistor $Q_{11}$ is turned ON and the bit line is charged toward the level $V_{cc}$, while, if the voltage level of the bit line is low, the transistor $Q_{11}$ is not turned ON and the bit line is not charged.

Returning to Fig. 8, after the write operation or refresh operation is performed with respect to the memory cell MC at the level $V_{cc}$ of 4.5V and then the voltage level is changed to $V_{ss}$, the voltage level of the bit line $\overline{BL}$ becomes 4.5V and the voltage level of the bit line BL becomes 0V, as shown in Fig. 9. Thereafter, the signal BC is activated and the transistors $Q_1$, $Q_2$, and $Q_3$ are turned ON. Then the charges on the bit line $\overline{BL}$ are distributed to the bit line BL and thereby the voltage level of each of the bit lines has the same value of

$$2.25(=\frac{1}{2}\times 4.5)V.$$

Thereafter the aforesaid stand-by status begins from the time $t_0$, in which the voltage level of each bit line cannot be changed by, for example, a junction-leak current due to the voltage divider VD, and the voltage level 2.25V is fixedly maintained.

When the read operation is commenced, the word line WL is activated and the aforesaid voltage difference $\Delta V_{BL}$ between the bit lines BL and $\overline{BL}$ is created in accordance with the information stored in the memory cell MC. Next, the sense amplifier SA is driven so that the low voltage level of one of the bit lines is pulled down toward the level $V_{ss}$, while the high voltage level of the other bit line is pulled up toward the level $V_{cc}$ by means of one of the corresponding dynamic pull-up circuits DPU. Thus, the voltage difference therebetween is considerably amplified. The amplified difference voltage is transferred, via a column line (not shown), to a read-write amplifier (not shown).

The operations of the circuit shown in Fig. 8 will be explained with reference to Figs. 9 and 10.

1) In the case of a "0" read operation, if the voltage level is fixedly maintained to be $V_{cc}=4.5V$, the voltage level $V_{\overline{BL}}$ of the bit line $\overline{BL}$ does not change, because no dummy cell DMC exists as is illustrated in Fig. 8. Thus, the following equation is obtained.

$$V_{\overline{BL}}=V_c=2.25V \tag{23}$$

While, the voltage level $V_{BL}$ of the bit line BL is expressed by the following equation.

$$V_{BL}=V_c-V_c\frac{C_s}{C_B} =2.25V-2.25\frac{C_s}{C_B} \tag{24}$$

From the above equations (23) and (24), the following equation, regarding the voltage difference, is obtained,

$$\Delta V_{BL}= |V_{BL}-V_{\overline{BL}}| =2.25\frac{C_s}{C_B} \tag{25}$$

2) In the case of a "0" read operation, if the voltage level $V_{cc}$ changes, during the stand-by status, from 4.5V to 5.5V and the read operation is commenced immediately after the time $t_1$, the result is the same as that mentioned in the above paragraph 1). This is because, close to the time $t_1$, as seen from Fig. 9, the

8

voltage level at $N_1$ is about 0V and besides, the voltage level $V_C$ is kept almost at 2.25V due to the presence of the aforementioned time constant $\tau$.

3) In the case of a "0" read operation, if the voltage level $V_{CC}$ changes from 4.5V to 5.5V and the read operation is commenced at the time $t_2$ being far longer than the time $t_1$,

$$V_{\overline{BL}}=V_C=\frac{5.5}{2}=2.75V \qquad (26)$$

$$V_{BL}=V_C-(V_C-V_{N1})\frac{C_S}{C_B}$$

$$=2.75-(2.75-0.5)\frac{C_S}{C_B}$$

$$=2.75-2.25\frac{C_S}{C_B} \qquad (27)$$

From the equations (26) and (27), the following equation

$$\Delta V_{BL}=\mid V_{BL}-V_{\overline{BL}} \mid =2.25\frac{C_S}{C_B} \qquad (28)$$

is obtained.

4) In the case of a "1" read operation, if the voltage level is fixedly maintained to be $V_{CC}$=4.5V, the following equations (29) and (30) are obtained, regarding the bit lines $\overline{BL}$ and BL.

$$V_{\overline{BL}}=V_C=2.25V \qquad (29)$$

$$V_{BL}=V_C+(V_{CC}-V_C)\frac{C_S}{C_B}$$

$$=2.25+(4.5-2.25)\frac{C_S}{C_B}$$

$$=2.25+2.25\frac{C_S}{C_B} \qquad (30)$$

From the equations (29) and (30), the following equation

$$\Delta V_{BL}=\mid V_{BL}-V_{\overline{BL}} \mid =2.25\frac{C_S}{C_B} \qquad (31)$$

is obtained.

5) In the case of a "1" read operation, if the voltage level $V_{CC}$ varies, during the stand-by status, from 4.5V to 5.5V and the read operation is commenced immediately after the time $t_1$, the voltage level $V_C$ is held at about 2.25V and the voltage level at the node $N_1$ is held at about 4.5V, the result is the same as that mentioned in the above paragraph 4).

6) In the case of a "1" read operation, if the voltage level $V_{CC}$ changes from 4.5V to 5.5V and the read operation is commenced at the time $t_2$ being far longer than the time $t_1$, the following equations

$$V_{\overline{BL}}=V_C=\frac{5.5}{2}=2.75V \qquad (32)$$

9

$$V_{BL} = V_C + (V_{CC} - 0.5 - V_C)\frac{C_S}{C_B}$$

$$= 2.75 + (5.5 - 0.5 - 2.75)\frac{C_S}{C_B}$$

$$= 2.75 + 2.25\frac{C_S}{C_B} \tag{33}$$

are obtained.

From the equations (32) and (33), the following equation

$$\Delta V_{BL} = |V_{BL} - V_{\overline{BL}}| = 2.25\frac{C_S}{C_B} \tag{34}$$

is obtained.

The cases, mentioned in the above paragraphs 2), 3), 5) and 6) correspond to all possible cases, in which, first the "0" write or "1" write operation has been performed in the memory cell MC under a condition of $V_{CC} = 4.5V$. In such cases, the aforesaid results, corresponding to the equations (28) and (34), are identical, corresponding to the equations (25) and (31) which are obtained in the cases where the read operations are commenced under a condition of $V_{CC} = 4.5V$ (not 5.5V).

As explained above, one of the previously mentioned two defects can be overcome. That is, read error, due to the voltage change of the memory power source, can be eliminated. Further, three advantages are newly produced, the first one being that no dummy cell DMC is required for constructing the RAM, the second one being that a high speed read operation is expected, because the read operation can be commenced immediately after the time $t_1$, and the third one being that power consumption can be reduced in the RAM, because a very large resistance value of each of the resistors R in the voltage divider VD is allowed.

The present invention can overcome the other previously mentioned defect, i.e. that error in a RAM system often occurs due to a change in the level of the backgate voltage ($V_{BB}$) for biassing the substrate, in which the change of $V_{BB}$ is necessarily created in accordance with the voltage change developed at the bit lines BL and $\overline{BL}$. The circuit construction embodying the present invention, especially the aforementioned first circuitry, is very useful for suppressing the change in the backgate voltage $V_{BB}$. The first circuitry, as mentioned above, functions to supply a pre-charge voltage to the pre-charge circuit PRE, and the pre-charge voltage is defined as just the middle of the levels $V_{CC}$ and $V_{SS}$. In this case, the previously mentioned second circuitry, embodying the present invention, functions to supply a predetermined voltage to the capacitor $C_S$, i.e. to its second electrode, this predetermined voltage being

$$\frac{1}{2}(V_{CC} + V_{SS}).$$

Fig. 12 depicts a first graph used for explaining how $V_{BB}$ changes in proportion to the voltage of the line BL. This first graph is obtained when the semiconductor memory circuit of Fig. 1 or Fig. 3 is used. The meanings of respective reference symbols used in Fig. 12 have already been explained with reference to earlier Figures. In Fig. 12, the change in the backgate voltage $V_{BB}$ should be noted, which change is indicated by hatched lines surrounded by broken lines. The reason why the voltage $V_{BB}$ changes in such a wide range as illustrated in Fig. 12, will be explained hereinafter. The backgate voltage, that is, the voltage of the substrate $V_{BB}$, was determined in the prior art by an external biassing voltage generator. However, in recent years, the RAM system does not operate with such an external biassing voltage generator, but an identical biassing voltage is generated in the RAM system itself, by using a single power source of 5V($V_{CC}$). In this case, it is difficult to generate high power biassing voltage, compared to that of the external biassing voltage generator, and accordingly merely a low power biassing voltage is generated therein. To make the matter worse, since the bit lines BL and $\overline{BL}$ are fabricated by diffusion layers, a great amount of PN-junction capacity is created between the bit lines and the substrate. As a result, if a big change in the voltage level occurs in either one of the bit lines, this change of voltage is directly transmitted to the substrate, via the above-mentioned large PN-junction capacity. This is the reason why a large change in $V_{BB}$ occurs. For example, in Fig. 12, the voltage level $V_{BB}$ changes proportionally to the voltage change of the bit line BL. If such a large voltage change occurs in the bit line BL, the voltage level $V_{BB}$ may change in proportion to the voltage of the line BL.

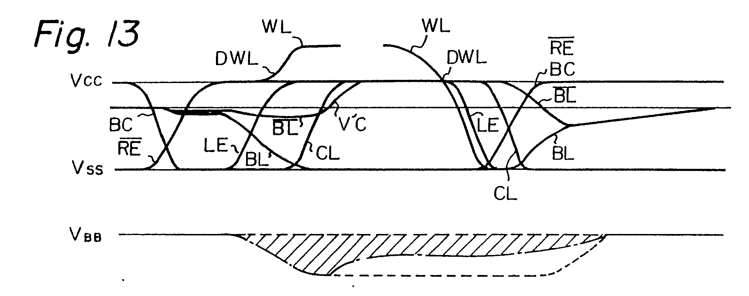

Fig. 13 depicts a second graph used for explaining the charge of $V_{BB}$. The second graph indicates an improvement with respect to the change of $V_{BB}$ shown in Fig. 12. As seen from Fig. 13, the change in $V_{BB}$, which is indicated by hatched lines surrounded by a chain-dotted line, is reduced as compared with the change in $V_{BB}$ shown in Fig. 12, also illustrated in Fig. 13 by a broken line. This is because the pre-charge voltage of both the bit lines BL and $\overline{BL}$ is reduced from the level $V_{cc}$ to the level $V_c'$ which is illustrated in Fig. 13.

The circuit construction shown in Fig. 8, embodying the present invention, especially the aforementioned first circuitry, is very useful for suppressing change in $V_{BB}$. The first circuitry (VD), as previously mentioned, functions to supply the pre-charge voltage ($V_c$) to the pre-charge circuit PRE, and the pre-charge voltage is defined as just the middle of the levels $V_{cc}$ and $V_{ss}$. In this case, the previously mentioned second circuitry, embodying the present invention, functions to supply a predetermined voltage to the capacitor $C_s$, i.e. to its second electrode, the predetermined voltage being

$$\frac{1}{2}(V_{cc}+V_{ss}).$$

In the circuit of Fig. 8, since the pre-charge voltage is determined to be

$$\frac{1}{2}(V_{cc}+V_{ss}),$$

the change in $V_{BB}$ caused by an upward voltage shift of one bit line is almost cancelled by the change in $V_{BB}$ caused by a downward voltage shift of the other bit line, thereby considerably decreasing the overall change in $V_{BB}$.

As mentioned above, the present invention can overcome the aforesaid two defects, and accordingly the read error, due to the change of the memory power source, cannot occur, and also the change of $V_{BB}$ in the substrate can be stabilized. At the same time, the following three advantages are produced, firstly, that no dummy cell is required, secondly, that a high speed read operation can be achieved and lastly that the power consumption in the voltage divider VD can be reduced as compared with the prior art.

It should be noted that the circuitry of Figures 8 and 11 provides the subject-matter also of the applicant's European patent application number 87 104 318.8.

**Claims**

1. A semiconductor memory circuit comprising: a plurality of word lines (WL); a plurality of bit lines (BL, $\overline{BL}$); respective memory cells (MC) located at cross points of the word lines and the bit lines, each memory cell being comprised of a capacitor ($C_S$), having a first electrode and a second electrode, and a transfer-gate transistor ($Q_S$) connected in series with the capacitor ($C_S$) at the first electrode thereof; a plurality of pre-charge circuits (PRE) each arranged for charging one corresponding bit line to a pre-charge voltage ($V_c$) derived from a memory power source ($V_{cc}$); a plurality of sense amplifiers (SA) each arranged for amplifying the voltage level developed at one corresponding bit line so as to have a high voltage level or a low voltage level in accordance with the charge stored in one of the capacitors ($C_S$) corresponding to that bit line; first circuitry (VD) employed for supplying to the pre-charge circuit (PRE) the said pre-charge voltage ($V_c$) the level of which is halfway between the said high voltage level and the said low voltage level; and second circuitry connected for applying a predetermined voltage to each said capacitor ($C_S$) at the second electrode thereof;

characterised in that the level of the said predetermined voltage applied by the said second circuitry is halfway between the said high voltage level and the said low voltage level developed at a bit line.

2. A semiconductor memory circuit as claimed in claim 1, wherein the said first circuitry and the said second circuitry are commonly fabricated as a voltage divider (VD).

3. A semiconductor memory circuit as claimed in claim 2, wherein the said high voltage level and the said low voltage level, developed at a bit line, are selected to be the levels of the higher voltage ($V_{cc}$) and the lower voltage ($V_{ss}$) sides respectively of an output of the said memory power source.

4. A semiconductor memory circuit as claimed in claim 3, wherein the said voltage divider (VD) divides a voltage difference between the said higher voltage ($V_{cc}$) and the said lower voltage ($V_{ss}$).

5. A semiconductor memory circuit as claimed in claim 4, wherein a dynamic pull-up circuit (DPU) is incorporated into the bit line (BL, $\overline{BL}$) so as to lead the said high voltage level of the bit line to the level of the said higher voltage ($V_{cc}$).

6. A semiconductor memory circuit as claimed in claim 5, wherein the said dynamic pull-up circuit (DPU) comprises an enhancement type MIS transistor ($Q_{11}$), having a gate ($g_1$), a first electrode ($e_{11}$) connected with a bit line (BL, $\overline{BL}$), and a second electrode ($e_{12}$) connected to receive the said higher voltage ($V_{cc}$); a depletion type MIS transistor ($Q_{12}$), having a gate ($g_2$) connected to receive the said lower voltage ($V_{ss}$), a first electrode ($e_{21}$) connected with the said bit line (BL, $\overline{BL}$), and a second electrode ($e_{22}$) connected to the said gate ($g_1$) of the enhancement type MIS transistor ($Q_{11}$); and a capacitor (C), having a first

electrode (e₁) connected to the said second electrode (e₂₂) of the depletion type MIS transistor (Q₁₂), and a second electrode (e₂) connected to receive a clock pulse (CL).

**Patentansprüche**

1. Halbleiterspeichervorrichtung mit: einer Vielzahl von Wertleitungen (WL); einer Vielzahl von Bitleitungen (BL, $\overline{BL}$); jeweiligen Speicherzellen (MC), die an Kreuzungspunkten der Wortleitungen und der Bitleitungen angeordnet sind, wobei jede Speicherzelle einen Kondensator (C_S), mit einer ersten und einer zweiten Elektrode, und einen Transfer-Gate-Transistor (Q_S) umfaßt, der mit dem Kondensator (C_S) an dessen erster Elektrode in Reihe verbunden ist; einer Vielzahl von Vor-Ladeschaltungen (PRE), die jeweils angeordnet sind, um eine entsprechende Bitleitung auf eine Vor-Ladespannung (V_c) aufzuladen, die von einer Speicherenergiequelle (V_cc) abgeleitet ist; einer Vielzahl von Leseverstärkern (SA), die jeweils angeordnet sind, um den Spannungepegel zu verstärken, der an einer entsprechenden Bitleitung entwickelt wird, um so einen hohen Spannungspegel oder einen niedrigen Spannungspegel in Übereinstimmung mit der Ladung zu haben, die in einem von den Kondensatoren (C_S) gespeichert ist, der derjenigen Bitleitung entspricht; einer ersten Schaltung (VD), die dazu verwendet wird, der Vor-Ladeschaltung (PRE) die genannte Vor-Ladespannung (V_c) zuzuführen, deren Pegel halbwegs zwischen dem genannten hohen Spannungspegel und dem genannten niedrigen Spannungspegel liegt; und einer zweiten Schaltung, die angeschlossen ist, um jedem der genannten Kondensatoren (C_S) an seiner zweiten Elektrode eine vorbestimmte Spannung zu liefern;

dadurch gekennzeichnet, daß der Pegel der genannten vorbestimmten Spannung, die von der genannten zweiten Schaltung zugeführt wird, halbwegs zwischen dem genannten hohen Spannungspegel und dem genannten niedrigen Spannungspegel liegt, der bei einer Bitleitung entwickelt wird.

2. Halbleiterspeichervorrichtung nach Anspruch 1, bei der die genannte erste Schaltung und die genannte zweite Schaltung gemainsam als ein Spannüngsteiler (VD) hergestellt sind.

3. Halbleiterspeicherschaltung nach Anspruch 2, bei der der genannte hohe Spannungspegel und der genannte niedrige Spannungspegel, die bei einer Bitleitung entwickelt werden, so ausgewählt werden, daß sie dei Pegel der hoheren Spannungsseiten (V_cc) beziehungsweise der niedrigeren Spannungsseiten (V_ss) eines Ausgangs der genannten Speicherenergiequelle sind.

4. Halbleiterspeichervorrichtung nach Anspruch 3, bei der der genannte Spannungsteiler (VD) eine Spannungsdifferenz zwischen der genannten höheren Spannung (V_cc) und der genannten niedrigeren Spannung (V_ss) teilt.

5. Halbleiterspeicherschaltung nach Anspruch 4, bei der eine dynamische Pull-up-Schaltung (DPU) in der Bitleitung (BL, $\overline{BL}$) eingeordnet ist, um so den genannten hoheren Spannungspegel der Bitleitung auf den Pegel der genannten hoheren Spannung (V_cc) zu führen.

6. Halbleiterspeicherschaltung nach Anspruch 5, bei der die genannte dynamische Pull-up-Schaltung (DPU) umfaßt: einen MIS-Transistor (Q₁₁) vom Anreicherungstyp, der ein Gate (g₁), eine erste Elektrode (e₁₁), die mit einer Bitleitung (BL, $\overline{BL}$) verbunden ist, und eine zweite Elektrode (e₁₂) hat, die verbunden ist, um die genannte höhere Spannung (V_cc) zu empfangen; einen MIS-Transistor (Q₁₂) vom Verarmungstyp, der ein Gate (g₂), das verbunden ist, um die genannte niedrigere Spannung (V_ss) zu empfangen, eine erste Elektrode (e₂₁), die mit der genannten Bitleitung (BL, $\overline{BL}$) verbunden ist und eine zweite Elektrode (e₂₂) hat, die mit dem genannten Gate (g₁) von dem MIS-Transistor (Q₁₁) vom Anreicherungstyp verbunden ist; und einen Kondensator (C), der eine erste Elektrode (e₁) hat, die mit der genannten zweiten Elektrode (e₂₂) von dem MIS-Transistor (Q₁₂) vom Verarmungstyp verbunden ist, und eine zweite Elektrode (e₂), die angeschlossen ist, um einen Taktimpuls (CL) zu empfangen.

**Revendications**

1. Circuit de mémoire à semiconducteur comprenant: un ensemble de fils de mot (WL); un ensemble de fils de bit (BL, $\overline{BL}$); des cellules de mémoire respectives (MC) placées aux points de croisement des fils de mot et des fils de bit, chaque cellule de mémoire étant constituée d'un condensateur (C_S), ayant une première électrode et une seconde électrode, et un transistor à grille de transfert (Q_S) connecté en série avec le condensateur (C_S) par sa première électrode; un ensemble de circuits de précharge (PRE) agencés chacun pour charger un fil de bit correspondant à une tension de précharge (V_c) dérivée d'une source de tension d'alimentation de mémoire (V_cc); un ensemble d'amplificateurs de détection (SA) agencés chacun pour amplifier le niveau de tension produit sur un fil de bit correspondant de manière à avoir un niveau haut de tension ou un niveau bas de tension selon la charge stockée dans un des condensateurs (C_S) correspondant à ce fil de bit; un premier circuit (VD) utilisé pour fournir au circuit de précharge (PRE) la tension de précharge (V_c) dont le niveau est à mi-distance entre le niveau haut de tension et le niveau bas de tension; et un second circuit connecté pour appliquer une tension prédéterminée à chaque condensateur (C_S) par sa seconde électrode;

caractérisé en ce que le niveau de la tension prédéterminée appliquée par le second circuit est à mi-distance entre le niveau haut de tension et le niveau bas de tension produits sur un fil de bit.

2. Circuit de mémoire à semiconducteur selon la revendication 1, dans lequel le premier circuit et le second circuit sont fabriqués en commun comme un diviseur de tension (VD).

3. Circuit de mémoire à semiconducteur selon la revendication 2, dans lequel le niveau haut de tension et le niveau bas de tension, produits sur un fil de bit, sont choisis pour qu'ils soient les niveaux respectivement des côtés de tension supérieure ($V_{cc}$) et de tension inférieure ($V_{ss}$) d'une sortie de la source de tension d'alimentation de mémoire.

4. Circuit de mémoire à semiconducteur selon la revendication 3, dans lequel le diviseur de tension (VD) divise la différence de tension entre la tension supérieure ($V_{cc}$) et la tension inférieure ($V_{ss}$).

5. Circuit de mémoire à semiconducteur selon la revendication 4, dans lequel un circuit élévateur dynamique (DPU) est incorporé dans le fil de bit (BL, $\overline{BL}$) de manière à conduire le niveau haut de tension du fil de bit jusqu'au niveau de la tension supérieure ($V_{cc}$).

6. Circuit de mémoire à semiconducteur selon la revendication 5, dans lequel le circuit élévateur dynamique (DPU) comprend un transistor à métal-isolant-semiconducteur MIS du type à enrichissement ($Q_{11}$), comportant une grille ($g_1$), une première électrode ($e_{11}$) connectée à un fil de bit (BL, $\overline{BL}$), et une seconde électrode ($e_{12}$) connectée pour recevoir la tension supérieure ($V_{cc}$); un transistor MIS du type à appauvrissement ($Q_{12}$), comportant une grille ($g_2$) connectée pour recevoir la tension inférieure ($V_{ss}$), une première électrode ($e_{21}$) connectée au fil de bit (BL, $\overline{BL}$), et une seconde électrode ($e_{22}$) connectée à la grille ($g_1$) du transistor MIS du type à enrichissement ($Q_{11}$); et un condensateur (C), comportant une première électrode ($e_1$) connectée à la seconde électrode ($e_{22}$) du transistor MIS du type à appauvrissement ($Q_{12}$), et une seconde électrode ($e_2$) connectée pour recevoir une impulsion d'horloge (CL).

# Fig. 1

Fig. 2

("O" Read)

# Fig. 3

# Fig. 4

("1" Read)

Fig. 5

Fig. 6 ("0" Read)

*Fig. 7* ("1" Read)

*Fig. 8*

Fig. 9  ("O" Read)

Fig. IO  ("I" Read)

*Fig. 11*

*Fig. 12*

Fig. 13